(19) **Europäisches Patentamt / European Patent Office / Office européen des brevets**

(11) **EP 2 337 167 B1**

(12) **FASCICULE DE BREVET EUROPEEN**

(45) Date de publication et mention
de la délivrance du brevet:
**12.12.2018 Bulletin 2018/50**

(51) Int Cl.:
*H01S 5/10* *(2006.01)*  *H01S 5/02* *(2006.01)*
*H01S 5/12* *(2006.01)*  *H01S 5/323* *(2006.01)*

(21) Numéro de dépôt: **10196329.6**

(22) Date de dépôt: **21.12.2010**

(54) **Laser hybride couplé à un guide d'onde**

Hybridlaser, mit einem Wellenleiter gekoppelt

Hybrid laser coupled to a waveguide

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2009 FR 0959301**

(43) Date de publication de la demande:
**22.06.2011 Bulletin 2011/25**

(73) Titulaire: **Commissariat à l'Énergie Atomique et aux Énergies Alternatives
75015 Paris (FR)**

(72) Inventeurs:
• **DUPONT, Tiphaine**
**38000 GRENOBLE (FR)**
• **GRENOUILLET, Laurent**
**38140 RIVES (FR)**

(74) Mandataire: **Cabinet Beaumont
4, Place Robert Schuman
B.P. 1529
38025 Grenoble Cedex 1 (FR)**

(56) Documents cités:
WO-A1-2010/091688    FR-A1- 2 909 491
US-A- 5 444 730    US-A1- 2009 154 517

• TIBERIO R C ET AL: "Facetless Bragg reflector surface-emitting AlGaAs/GaAs lasers fabricated by electron-beam lithography and chemically assisted ion-beam etching", JOURNAL OF VACUUM SCIENCE & TECHNOLOGY B (MICROELECTRONICS PROCESSING AND PHENOMENA) USA, vol. 9, no. 6, novembre 1991 (1991-11), pages 2842-2845, XP002594026, ISSN: 0734-211X
• VAWTER G A ET AL: "Monolithically integrated transverse-junction-stripe laser with an external waveguide in GaAs/AlGaAs", IEEE JOURNAL OF QUANTUM ELECTRONICS USA, vol. 25, no. 2, février 1989 (1989-02), pages 154-162, XP002594027, ISSN: 0018-9197

**EP 2 337 167 B1**

**Description**

Domaine de l'invention

La présente invention concerne les circuits intégrés combinant des circuits microélectroniques et photoniques, et plus particulièrement des circuits intégrés sur silicium, et plus particulièrement l'injection de lumière cohérente monomode dans un guide d'onde d'un circuit intégré par un laser hybride.

Exposé de l'art antérieur

Dans le domaine de la microélectronique, l'augmentation de la densité d'intégration est telle qu'elle fait apparaître certains problèmes. En particulier, la fréquence des circuits intégrés commence à être limitée par les interconnexions électriques et la puissance à dissiper par unité de surface sous forme de chaleur dans ces interconnexions commence à être un frein pour aller plus loin en performances.

Une solution envisagée pour pallier à ces problèmes est de remplacer les niveaux d'interconnexions électriques supérieurs par des interconnexions optiques, plus performantes en bande passante et moins consommatrices d'énergie, ces interconnexions optiques étant intimement intégrées au silicium des circuits microélectroniques.

Mais si le silicium peut être utilisé de manière très avantageuse pour la fabrication de composants optiques passifs, il présente l'inconvénient d'être un très mauvais émetteur de lumière. En effet, sa structure de bandes électroniques ne permet pas de transitions radiatives directes. L'intégration d'un laser sur silicium passe donc par le report d'un empilement multicouches de semi-conducteurs de type III-V (par exemple, familles GaAs ou InP et leurs alliages associés) sur une plaquette de silicium, par exemple de type silicium sur isolant (SOI).

Le report de structures III-V sur SOI s'effectue par collage moléculaire (par le biais d'une couche de $SiO_2$) ou par collage adhésif (par le biais d'une couche de polymères).

On s'intéressera ici plus particulièrement au cas où la cavité laser est de type DFB (acronyme de Distributed FeedBack, ou laser à contre-réaction distribuée), à savoir un laser où le résonateur comprend une structure périodique qui agit comme un réflecteur sélectif en longueur d'onde, distribué le long du matériau à gain. Ce type de laser est décrit dans de nombreuses publications et par exemple dans la demande de brevet US 2004/0004217.

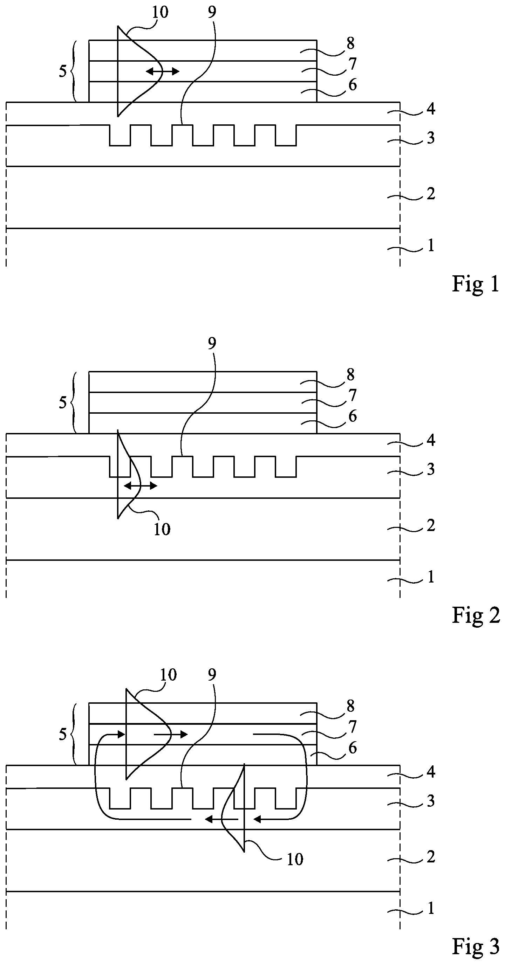

Comme l'illustrent les figures 1 et 2, ce type de structure comprend un substrat de type SOI comprenant sur un support 1, généralement une tranche de silicium, une couche mince isolante 2, généralement de l'oxyde de silicium et une couche mince de silicium monocristallin ou amorphe 3. La surface de la couche de silicium 3 comprend une structure périodique définissant un réseau 9. Sur ce substrat, on rapporte, avec interposition éventuelle d'une couche d'interface 4 un empilement planaire multicouches 5 de semiconducteur III-V comprenant par exemple une couche 6 d'InP dopée de type N, une couche 7 d'InGaAsP intrinsèque contenant un ou plusieurs puits quantiques et une couche 8 d'InP dopée de type P. L'empilement III-V 5 est associé à des électrodes de polarisation, non représentées. Plusieurs moyens sont connus pour rapporter une telle structure sur la surface supérieure d'un substrat de type SOI.

L'empilement III-V 5 est une structure guidante possédant du gain dont la fonction est de générer des photons. La couche de silicium 3 est un guide d'onde SOI passif dont la fonction est de collecter les photons générés dans l'empilement III-V et de les guider au-delà de la zone recouverte par l'empilement jusqu'aux différents dispositifs du circuit. La fonction du réseau 9 est d'agir comme réflecteur distribué, permettant aux photons de traverser plusieurs fois la zone de gain. Le composant laser est défini par la réunion de l'empilement III-V 5 (zone de gain), du guide d'onde SOI (coupleur externe) et du réseau 9 (réflecteur). Il s'agit d'un laser hybride III-V/Si.

Avec une telle structure et selon sa répartition d'indices optiques, le mode laser est principalement guidé soit dans l'empilement III-V 5 ainsi que représenté dans la figure 1, soit dans la couche de silicium 3, ainsi que représenté dans la figure 2. Dans le premier cas, le gain modal est favorisé aux dépens de l'efficacité d'extraction de puissance vers le guide d'onde silicium 3. Dans le deuxième cas, l'efficacité d'extraction de puissance vers le guide d'onde silicium 3 est favorisé aux dépens du gain modal.

L'inconvénient de ce type de structure et de ses variantes est donc qu'elle impose un compromis entre seuil laser et puissance collectée dans le guide d'onde silicium 3.

Résumé

Un objet de la présente invention est d'améliorer ce type de structure et plus particulièrement de permettre à la fois un faible seuil laser et une forte puissance collectée dans le guide d'onde silicium 3.

Pour atteindre ces objets, un mode de réalisation de la présente invention prévoit un procédé d'introduction de lumière dans un guide d'onde formé sur la surface supérieure d'un substrat de microélectronique, au moyen d'un dispositif laser à contre-réaction distribuée formé par l'association d'une structure de type SOI dont une partie constitue ledit guide d'onde, d'un empilement de matériaux semi-conducteurs III-V à gain recouvrant partiellement le guide d'onde, et d'un réseau optique, dans lequel le pas de réseau est choisi pour que la puissance optique du faisceau laser circule en boucle de l'empilement III-V au guide d'onde.

Selon la présente invention, le pas de réseau est choisi de sorte que :

$$\beta_{SOI}(\omega_2) + \beta_{III-V}(\omega_2) = 2n\pi/a,$$

et

$$\beta_{SOI}(\omega_2) \neq \beta_{III-V}(\omega_2)$$

avec :

a : pas de réseau,
$\omega_2$ : fréquence du mode,
$\beta_{SOI}$ : constante de propagation dans le guide d'onde,
$\beta_{III-V}$ : constante de propagation dans ledit empilement,
n : un nombre entier.

Selon un mode de réalisation de la présente invention, la longueur du réseau est choisie de sorte que :

$$R = \tanh^2(2\kappa L)$$

avec :

L : longueur du réseau,
K : constante de couplage contradirectionnel,
R : réflectivité du réseau

de sorte que R soit compris entre 0,60% et 0,99%.

La présente invention prévoit un dispositif laser à contre-réaction distribuée formé par l'association d'une structure de type SOI dont une partie constitue un guide d'onde formé sur la surface supérieure d'un substrat de microélectronique, d'un empilement de matériaux semi-conducteurs III-V à gain recouvrant partiellement le guide d'onde, et d'un réseau optique dont la période est choisie de façon à permettre une circulation en boucle de la puissance optique de l'empilement III-V au guide d'onde.

Selon un mode de réalisation de la présente invention, le réseau est formé d'évidements périodiques creusés dans la surface supérieure d'un guide d'onde en silicium gainé d'oxyde de silicium.

Selon la présente invention, le pas de réseau est choisi de sorte que :

$$\beta_{SOI}(\omega_2) + \beta_{III-V}(\omega_2) = 2n\pi/a,$$

et

$$\beta_{SOI}(\omega_2) \neq \beta_{III-V}(\omega_2)$$

avec :

a : pas de réseau,
$\omega_2$ : fréquence du mode,
$\beta_{SOI}$ : constante de propagation dans le guide d'onde,
$\beta_{III-V}$ : constante de propagation dans ledit empilement,
n : un nombre entier.

Selon un mode de réalisation de la présente invention, la longueur du réseau est choisie de sorte que :

$$R = \tanh^2(2\kappa L)$$

avec :

L :      longueur du laser,
$\kappa$ :      constante de couplage contradirectionnel,
R :      réflectivité du réseau

de sorte que R soit compris entre 0,60% et 0.99%.

Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :

la figure 1 est une vue en coupe d'une structure laser DFB formée par un empilement III-V et un guide d'onde SOI dans lequel le mode laser est guidé par l'empilement III-V ;
la figure 2 est une vue en coupe d'une structure laser DFB formée par un empilement III-V et un guide d'onde SOI dans lequel le mode laser est guidé par le guide d'onde SOI ;
la figure 3 est une vue en coupe d'une structure laser DFB formée par un empilement III-V et un guide d'onde SOI dans lequel le mode laser circule en boucle de l'empilement III-V au guide d'onde SOI ;
la figure 4 illustre des courbes de dispersion $\omega(\beta III\text{-}V)$ et $\omega(\beta SOI)$ en l'absence de variation périodique de l'indice ;
la figure 5 illustre des courbes de dispersion théoriques $\omega(\beta III\text{-}V)$ and $\omega(\beta SOI)$ en présence d'une variation périodique de l'indice ; et
la figure 6 illustre un diagramme de dispersion.

Comme cela est habituel dans la représentation des circuits intégrés, les figures 1, 2 et 3 ne sont pas tracées à l'échelle.

Description détaillée

La présente invention se base sur une analyse approfondie du couplage entre un empilement multicouches III-V et un guide d'onde de type SOI en présence d'une variation périodique de l'indice. On peut classer les structures connues selon deux catégories.
Les structures de la première catégorie utilisent un guide d'onde SOI de plus fort indice effectif que l'empilement III-V. Le mode laser est alors principalement guidé par le guide SOI et seule sa queue évanescente recouvre la zone de gain. Il s'agit du cas de figure représenté dans la figure 2.
Ce type de laser favorise donc l'efficacité d'extraction de puissance dans le guide SOI aux dépens du gain dans l'empilement III-V. Le facteur de confinement du mode dans la zone de gain est très faible et diminue exponentiellement avec la distance entre le laser et le guide. Ceci implique que le régime laser ne pourra être atteint qu'avec l'utilisation d'une faible épaisseur de collage. Par exemple, des résultats publiés dans la littérature indiquent que pour un guide SOI de 700 nm d'épaisseur, le facteur de confinement dans les puits quantiques passe de 1% pour une épaisseur d'interface de collage nulle à 0,1% pour 100 nm.
Compte tenu de l'indice des matériaux mis en jeu, le guide d'onde SOI doit être relativement épais (~700 nm) de sorte que son indice effectif soit plus grand que l'indice effectif du guide III-V. Ces guides sont encombrants et de surcroît multi-modes. Le passage à des guides monomodes n'est pas aisé et prend de la place sur le circuit.
Les structures de la deuxième catégorie utilisent à l'inverse une épitaxie III-V de plus fort indice effectif que le guide d'onde SOI. Le mode laser est alors principalement guidé par la structure III-V et seule sa queue évanescente recouvre le guide d'onde SOI. Ce type de laser favorise donc le gain aux dépens de l'efficacité d'extraction de puissance vers le guide SOI. La puissance extraite est limitée par la faible fraction du mode recouvrant le guide SOI.
Les deux structures ci-dessus ont en commun que le faisceau laser dans la couche de silicium se propage dans la même direction que le faisceau laser dans la couche III-V.
En plus de leur faible rendement, ces deux structures présentent l'inconvénient d'être très peu tolérantes aux variations d'épaisseurs de la couche d'interface 4, car le gain dans le premier cas et le taux de couplage dans le deuxième suivent une décroissance exponentielle avec l'augmentation de l'épaisseur des couches.

Détermination du couplage contradirectionnel entre l'empilement III-V et le guide d'onde SOI

Les inventeurs ont montré que ces inconvénients résultent essentiellement du choix de la période du réseau permettant le fonctionnement du laser. La présente invention propose un dispositif dont l'allure structurelle est similaire à celle de l'art antérieur représenté en figures 1 et 2 mais dans lequel la période du réseau est choisie de façon à générer un couplage contradirectionnel résonant entre le mode propre de l'empilement III-V et celui du guide d'onde SOI : le mode qui se propage le long de l'empilement III-V est progressivement couplé au mode du guide SOI se propageant dans le sens opposé et inversement. Ce cas de figure est illustré dans la figure 3. Il résulte de ce couplage un échange continu de puissance optique entre l'empilement III-V et le guide SOI aboutissant à un effet de contre-réaction distribuée. L'avantage majeur de ce type de couplage est que le mode profite du gain sur sa zone de plus forte amplitude tout en conservant une forte efficacité d'extraction vers le guide SOI. De plus, le couplage entre l'empilement III-V et le guide SOI étant de type résonant, l'épaisseur de la couche d'interface 4 est peu critique. Contrairement aux lasers DFB III-V sur silicium développés précédemment, le réseau n'est pas uniquement utilisé pour permettre le recyclage de photons mais aussi pour coupler les modes propres des deux guides.

On considère, en figure 3, l'empilement III-V 5 et la région de la couche mince de silicium 3. Ces deux régions peuvent être considérées comme deux guides d'ondes voisins : un guide d'onde III-V avec du gain, et un guide d'onde en silicium passif. Ces deux guides sont enterrés dans une gaine de plus faible indice optique tel que de l'oxyde de silicium $SiO_2$. Les constantes de propagation de leurs modes propres sont respectivement notées $\beta$III-V et $\beta$SOI. Ces constantes sont reliées, pour chaque guide d'onde, à la fréquence du mode par la relation de dispersion :

$$\frac{\omega}{c}d\sqrt{n_1^2-\beta^2}-2\,\text{Arctan}\left(g\,\frac{\sqrt{\beta^2-n_2^2}}{\sqrt{n_1^2-\beta^2}}\right)=m\pi \;; \qquad \texttt{m=0, 1, 2, ... (1)}$$

avec :

$\omega$ : fréquence du mode,
$\beta$ : constante de propagation,
d : hauteur du guide,
$n_1$ : indice optique du coeur du guide (III-V ou Si),
$n_2$ : indice optique du gainage ($SiO_2$),
m : ordre du mode considéré (pour le mode fondamental, m=0).

L'équation (1) est valable pour les modes TE et une équation similaire existe pour les modes TM. La fréquence du mode est reliée à la longueur d'onde par la relation $\omega=2\pi c/\lambda$, tandis que la constante de propagation est directement reliée à l'indice effectif par la relation $\beta = 2\pi n_{eff}/\lambda$..

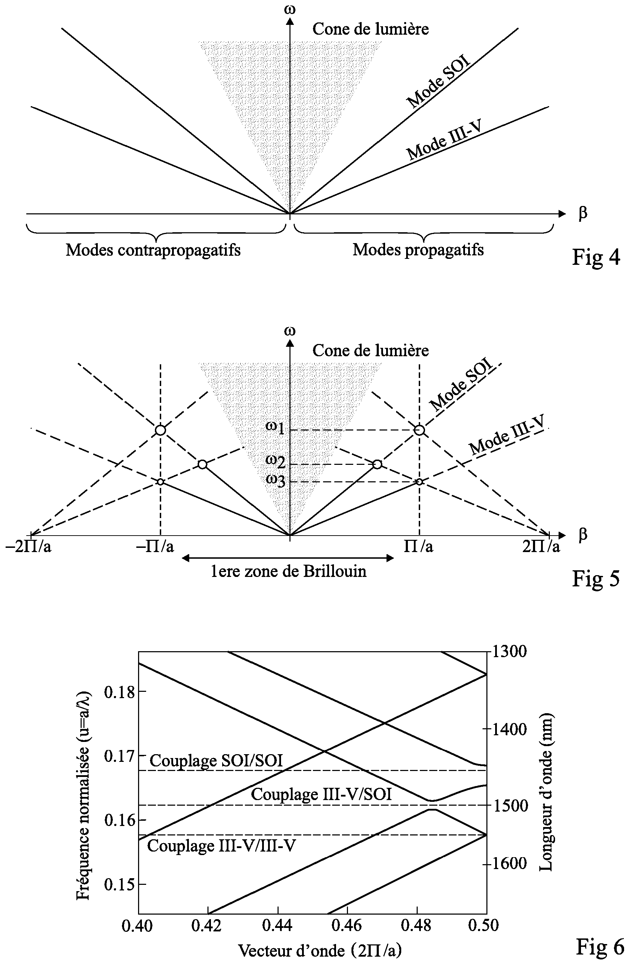

Une représentation schématique des courbes de dispersion $\omega(\beta$III-V$)$ et $\omega(\beta$SOI$)$ en l'absence de variation périodique de l'indice est donnée dans la figure 4. On distingue les modes se propageant dans le sens positif des modes se propageant dans le sens négatif par le signe de la pente de la courbe de dispersion $\omega(\beta)$. Autrement dit, les modes ayant une courbe de dispersion $\omega(\beta)$ dont la pente est positive se propagent dans un sens tandis que les modes ayant une pente négative se propagent dans le sens opposé.

Selon le théorème de Floquet-Bloch, lorsqu'une variation périodique de l'indice est ajoutée au système, un nombre infini d'harmoniques spatiaux des modes est créé tous les multiples entiers de $2\pi/a$ (a étant la période du réseau). Les courbes de dispersion théoriques $\omega(\beta$III-V$)$ et $\omega(\beta$SOI$)$ en présence d'un réseau gravé dans le guide silicium sont schématisées dans la figure 5. La première zone de Brillouin comprise entre $-\pi/a$ et $\pi/a$ contient tous les états possibles du système (tous les états extérieurs y trouvent leurs équivalents) si bien que l'analyse du problème peut se limiter à l'analyse de cette zone.

Les points d'anti-croisement correspondent à des points de couplage résonants associés à l'ouverture d'une bande interdite. L'ouverture de cette bande interdite est d'autant plus grande que le couplage est fort. En figure 5, on distingue trois fréquences de couplage distinctes à savoir $\omega$1, $\omega$2 et $\omega$3.

Aux fréquences $\omega$1 et $\omega$3, les conditions de Bragg suivantes sont satisfaites :

$$2\beta_{III-V}(\omega_3) = 2n\pi/a \qquad\qquad (2)$$

$$2\beta_{SOI}(\omega_1) = 2n\pi/a, \qquad\qquad (3)$$

n étant un nombre entier.

Ces conditions correspondent respectivement aux couplages contradirectionnels III-V/III-V et SOI/SOI de type "direct Bragg" représentés respectivement dans les figures 1 et 2 : le mode qui se propage dans un sens dans l'un des deux guides transfère son énergie au même mode qui se propage dans le sens opposé. L'onde électromagnétique est donc réfléchie sans échanges d'énergie entre les deux guides.

Ce type de couplage est utilisé dans la conception des lasers DFB de l'art antérieur.

A la fréquence ω2 la condition suivante est remplie :

$$\beta_{SOI}(\omega_2) + \beta_{III-V}(\omega_2) = 2n\pi/a \qquad (4)$$

où : n est un nombre entier, et

$$\beta_{SOI}(\omega_2) \neq \beta_{III-V}(\omega_2) \qquad (5)$$

L'équation (4) correspond au couplage contradirectionnel III-V/SOI de type "échange de Bragg" (Bragg exchange) représenté dans la figure 3. Le mode qui se propage dans un sens dans le premier guide transfère son énergie au mode qui se propage dans le sens opposé dans le deuxième guide.

Ainsi, on choisit ici la période du réseau de sorte que la fréquence ω2 soit dans le spectre de gain du matériau actif III-V. A cette fréquence particulière, le champ optique doit circuler en boucle du guide III-V au guide SOI. Ce phénomène de circulation, en plus de fournir de la contre-réaction distribuée, permet au mode de bénéficier du gain sur sa zone de plus forte amplitude tout en garantissant une forte efficacité d'extraction de la puissance vers le guide SOI. Il faut noter que le fait d'avoir $\beta_{III-V} < \beta_{SOI}$ ou $\beta_{III-V} > \beta_{SOI}$ dans la gamme des fréquences de travail ne change pas l'équation (4) et ne change donc pas le principe de fonctionnement du laser.

Selon la théorie des modes couplés, la force du couplage contradirectionnel est donnée par la constante de couplage K qui peut être calculée de manière analytique au moyen de la relation suivante :

$$\kappa = \frac{\omega\varepsilon_0}{4} \iint \Delta\varepsilon \Psi_{III-V} \Psi_{SOI} dx dy \ . \qquad (5)$$

La direction de propagation est orientée selon l'axe z. $\Psi_{III-V}$ et $\Psi_{SOI}$ sont les fonctions d'ondes des modes propres du III-V et du SOI. Ces fonctions d'ondes déterminent le profil de champ des modes et se calculent en résolvant les équations de Maxwell. La fonction $\Delta\varepsilon$ est une série de Fourier définissant la variation périodique de l'indice :

$$\Delta\varepsilon(x, y, z) = \sum_{m \neq 0} \Delta\varepsilon_m(x, y) exp\left(-jm\frac{2\pi}{a}z\right). \qquad (6)$$

En traçant les courbes de dispersion des modes supportés par le dispositif complet à l'aide d'un algorithme de calcul tel que la RCWA (Rigorous Coupled-Wave Analysis), il est également possible de déduire la constante de couplage à partir de l'ouverture de la bande interdite au moyen de l'équation suivante :

$$\Delta u = \frac{a}{2\pi} \frac{4\kappa}{n_{gIII-V} + n_{gSOI}} \ . \qquad (7)$$

avec :

    $\Delta u$ : ouverture de la bande interdite (unités de a/λ),
    a : période du réseau,
    $\kappa$ : constante de couplage contradirectionnel,
    ngIII-V et ngSOI : indices de groupe des modes III-V et SOI.

Les indices de groupe des modes peuvent se calculer simplement à l'aide de la relation ng=c/vg, où vg est la vitesse de groupe et correspond à la pente de la courbe de dispersion.

Dans le cas d'un laser fonctionnant sur un couplage de type "échange de Bragg", la réflectivité en fonction de la constante de couplage et de la longueur du laser est donnée par :

$$R = \tanh^2(2\kappa L).\qquad(8)$$

La longueur du laser sera donc choisie en fonction de la constante de couplage et selon la réflectivité souhaitée au moyen de l'équation (8).

Optimisation de la structure

Un phénomène de couplage parasite, le couplage directionnel, doit être considéré afin d'optimiser les dimensions des guides III-V et SOI, ainsi que de la profondeur de gravure du réseau. Le couplage directionnel correspond au transfert de puissance entre deux modes de guides différents se propageant dans le même sens. L'efficacité de couplage directionnel est donnée par la théorie des modes couplés par la relation suivante

$$F = \frac{1}{1+\left(\dfrac{\Delta_{dir}}{\kappa_{dir}}\right)^2}.\qquad(9)$$

Le désaccord de phase $\Delta_{dir}$ est lié à la différence entre les constantes de propagation des modes propres selon la relation suivante :

$$\Delta_{dir} = \frac{\beta_{III-V} - \beta_{SOI}}{2}.\qquad(10)$$

La constante de couplage directionnel $\kappa_{dir}$ détermine la force du couplage directionnel et se calcule de manière analytique au moyen des relations suivantes :

$$\kappa_{dir} = \sqrt{\kappa_{III-V/Si} \times \kappa_{Si/III-V}}.\qquad(11)$$

$$\kappa_{III-V/Si} = \frac{\omega\varepsilon_0}{4}\iint_{\infty}\left[n_2^2(x,y) - n_{Si}^2(x,y)\right]\Psi_{III-V}\Psi_{SOI}\,dxdy.\qquad(12)$$

$$\kappa_{Si/III-V} = \frac{\omega\varepsilon_0}{4}\iint_{\infty}\left[n_2^2(x,y) - n_{III-V}^2(x,y)\right]\Psi_{III-V}\Psi_{SOI}\,dxdy.\qquad(13)$$

où n2 est l'indice optique du gainage.

Le couplage directionnel est un facteur limitant du couplage contradirectionnel. Une structure optimisée doit donc minimiser l'efficacité de couplage directionnel F. La démarche à suivre est donc de tracer la fonction F($\Delta$dir, $\kappa$dir) pour plusieurs épaisseurs d'interface de collage et profondeurs de gravure du réseau puis de déterminer quelle hauteur de guide SOI sera appropriée à une épitaxie III-V fixée. Les guides III-V et SOI étant potentiellement multimodes, cette démarche doit être répétée pour tous les couplages directionnels possibles entre les différents modes.

Les pertes optiques dans le guide d'onde SOI 3 au niveau de la transition entre la zone structurée par le réseau 9 et la zone non structurée peuvent être réduites par une adaptation progressive du facteur de remplissage du réseau à l'approche de la transition.

D'autre part, l'ajout d'une variation progressive de l'une des dimensions du guide SOI ou du guide III-V (transition adiabatique en forme d'entonnoir) de chaque côté du dispositif, au-delà de la zone structurée par le réseau, permet de transférer les photons guidés par l'empilement III-V vers le guide SOI de façon à augmenter la puissance de sortie.

Enfin, il est connu que les lasers DFB ont une émission bi-mode (deux longueurs d'ondes d'émission proches), l'ajout d'un défaut (communément appelé lame quart d'onde) permet de briser la symétrie du réseau et de forcer l'émission monomode du laser.

Exemple de réalisation

On indique ci-après uniquement à titre d'exemple, pour fixer les idées un exemple de dimensionnement d'un mode de réalisation permettant d'atteindre les objectifs de la présente invention.

- Epitaxie III-V d'épaisseur comprise entre 600 nm et 2 $\mu$m et d'indice effectif compris entre 2,5 et 3,2. L'épitaxie est un empilement laser issu par exemple de la famille de l'InP ou du GaAs et de leurs alliages associés. Elle comporte une zone active émettrice de lumière contenant un ou plusieurs puits quantiques. La zone active est incluse dans la zone i d'une jonction p-i-n afin de permettre le pompage électrique du laser. Le spectre de gain de la structure est par exemple centré à une longueur d'onde de 1,5 $\mu$m.
- Guide d'onde SOI d'épaisseur comprise entre 220 nm et 700 nm, gravé sur une profondeur comprise entre 20 nm et 100 nm, d'indice effectif compris entre 2 et 3,4. A titre de variante, le réseau peut-être gravé dans une couche de matériau autre que le silicium (par exemple du nitrure de silicium) déposée en surface du guide SOI.
- Distance entre les deux guides (correspondant à l'épaisseur de l'interface de collage) comprise entre 50 et 250 nm, avec un matériau d'interface d'indice de l'ordre de 1,45. Le matériau utilisé est de manière usuelle de la silice SiO$_2$ ou un polymère adapté au collage de type adhésif. Dans le cadre de l'invention, il peut également s'agir d'ITO, d'AlN, de nanocristaux... La contrainte est que le matériau doit être relativement transparent dans la plage de longueurs d'onde visée (ici la plage infrarouge couramment utilisée pour les télécommunications, de 1,3 $\mu$m à 1,55 $\mu$m).
- Indices effectifs des deux guides d'ondes et distance les séparant, choisis de sorte que l'efficacité de couplage directionnel donnée par l'équation (9) soit minimisée à la longueur d'onde de travail.
- Période du réseau fixée par la relation de l'équation (4) en fonction de la longueur d'onde d'émission et des indices effectifs des guides III-V et SOI.
- Longueur de laser avantageusement comprise entre 100 $\mu$m et 1 mm selon l'épaisseur de collage choisie.

Les calculs suivants sont réalisés pour une structure formée d'un empilement III-V de 600 nm d'épaisseur et d'un guide d'onde SOI de 260 nm d'épaisseur comportant en sa surface un réseau gravé sur 40 nm de profondeur. A une longueur d'onde de 1,5 $\mu$m, les indices effectifs de ces deux guides d'ondes sont respectivement de 3,16 et 2,99. Les guides d'ondes sont séparés par une couche de collage de 100 nm d'épaisseur. Le diagramme de dispersion de la structure donné dans la figure 6 est calculé par un algorithme de calcul de type RCWA. L'ouverture de bande interdite correspondant au couplage Bragg exchange III-V/SOI apparait à la fréquence normalisée u ($a/\lambda$) de 0,162 (soit $\lambda$ = 1500 nm). Le couplage direct Bragg III-V/III-V et SOI/SOI apparaissent aux fréquences normalisées u = 0,158 (soit $\lambda$ = 1544 nm) et u = 0,168 (soit $\lambda$ = 1452 nm), respectivement. En mesurant l'ouverture de la bande interdite centrée à 1500 nm, on calcule la constante de couplage $\kappa$ au moyen de l'équation (7) et on la trouve égale à 39,5 mm$^{-1}$. En utilisant l'équation (8), on calcule qu'un laser long de seulement 100 $\mu$m sera nécessaire pour obtenir une réflectivité du réseau de 93%. Les mêmes calculs répétés sur une structure utilisant une épaisseur de collage de 200 nm montrent qu'un laser long de seulement 300 $\mu$m sera nécessaire pour obtenir une réflectivité équivalente.

Une simulation optique effectuée par les inventeurs donne les résultats suivants. La puissance détectée dans le guide III-V est plus de dix fois supérieure à la fréquence de couplage III-V/SOI qu'à la fréquence SOI/SOI. L'effet laser à cette dernière fréquence est donc peu probable du fait du faible gain dont bénéficiera le mode. A la fréquence de couplage III-V/SOI au contraire, le champ est partagé de manière homogène entre les guides III-V et SOI ce qui permet à la fois une grande quantité de gain et une forte efficacité d'extraction vers le guide SOI.

Avantages de l'invention

La structure décrite ici permet donc :

- au mode de bénéficier du gain sur sa zone de plus forte amplitude tout en conservant une forte efficacité d'extraction de puissance vers le guide SOI,
- de relaxer les contraintes sur l'épaisseur de collage, et donc de faciliter l'intégration technologique car le couplage est de type résonant (des simulations montrent qu'une épaisseur de collage de plus de 200 nm est utilisable),
- de conserver une épaisseur de guide d'onde silicium comprise entre 200 et 300 nm,
- d'avoir une constante de couplage importante et donc un laser court (<500 $\mu$m),
- d'avoir un laser monomode longitudinal (et éventuellement transverse) avec l'utilisation d'une lame quart d'onde.

Des modes de réalisation particuliers de la présente invention ont été décrits. Diverses variantes et modifications apparaîtront à l'homme de l'art. En particulier, toutes les indications numériques n'ont été indiquées qu'à titre d'exemple.

Pour contrôler avec précision la hauteur du réseau, il est possible de graver le réseau non pas dans le silicium mais à la surface d'un autre matériau déposé sur le silicium pour un arrêt de gravure sélectif. Cet autre matériau peut être du SiGe ou du SiN.

Un avantage particulier du dispositif décrit ici est que la variation de la longueur d'onde d'émission laser avec une variation de facteur de remplissage du réseau est environ deux fois moins grande que dans les dispositifs antérieurs. Avec un contrôle précis du facteur de remplissage du réseau, il est possible avec ce dispositif de réaliser sur une même tranche un grand nombre de lasers côte-à-côte, émettant à des longueurs d'ondes très proches. Ce type de réalisation présente un grand intérêt pour les systèmes multiplexés en longueur d'onde (WDM).

## Revendications

1. Procédé d'introduction de lumière dans un guide d'onde en silicium (3) formé sur la surface supérieure d'un substrat de microélectronique, au moyen d'un dispositif laser à contre-réaction distribuée formé par l'association d'une structure de type SOI dont une partie constitue ledit guide d'onde (3), d'une couche d'interface (4), d'un empilement de matériaux semi-conducteurs III-V à gain (5) recouvrant partiellement le guide d'onde (3), et d'un réseau optique (9) formé dans la surface supérieure du guide d'onde, dans lequel le pas de réseau est choisi pour que la puissance optique du faisceau laser circule en boucle de l'empilement III-V (5) au guide d'onde (3), dans lequel le pas de réseau est choisi de sorte que :

$$\beta_{SOI}(\omega_2) + \beta_{III-V}(\omega_2) = 2n\pi/a,$$

et

$$\beta_{SOI}(\omega_2) \neq \beta_{III-V}(\omega_2)$$

avec :

a : pas de réseau,
$\omega_2$ : fréquence du mode,
$\beta_{SOI}$ : constante de propagation dans le guide d'onde,
$\beta_{III-V}$ : constante de propagation dans ledit empilement,
n : un nombre entier.

2. Procédé selon la revendication 1, dans lequel la longueur du réseau est choisie de sorte que :

$$R = \tanh^2(2\kappa L)$$

avec :

L : longueur du réseau,
$\kappa$ : constante de couplage contradirectionnel,
R : réflectivité du réseau

de sorte que R soit compris entre 0,60% et 0,99%.

3. Dispositif laser à contre-réaction distribuée formé par l'association d'une structure de type SOI dont une partie constitue un guide d'onde (3) formé sur la surface supérieure d'un substrat de microélectronique, d'une couche d'interface (4), d'un empilement de matériaux semi-conducteurs III-V à gain (5) recouvrant partiellement le guide d'onde (3), et d'un réseau optique (9) formé dans la surface supérieure du guide d'onde dont la période est choisie de façon à permettre une circulation en boucle de la puissance optique de l'empilement III-V (5) au guide d'onde (3), dans lequel le réseau est formé d'évidements périodiques creusés dans la surface supérieure d'un guide d'onde en silicium gainé d'oxyde de silicium, et dans lequel le pas de réseau est choisi de sorte que :

$$\beta_{SOI}(\omega_2) + \beta_{III-V}(\omega_2) = 2n\pi/a,$$

et

$$\beta_{SOI}(\omega_2) \neq \beta_{III-V}(\omega_2)$$

avec :

a : pas de réseau,
$\omega_2$ : fréquence du mode,
$\beta_{SOI}$ : constante de propagation dans le guide d'onde,
$\beta_{III-V}$ : constante de propagation dans ledit empilement,
n : un nombre entier.

**4.** Dispositif selon la revendication 3, dans lequel la longueur du réseau est choisie de sorte que :

$$R = \tanh^2(2\kappa L)$$

avec :

L : longueur du laser,
$\kappa$ : constante de couplage contradirectionnel,
R : réflectivité du réseau

de sorte que R soit compris entre 0,60% et 0,99%.

**Patentansprüche**

**1.** Verfahren zum Einführen von Licht in einen Wellenleiter (3), der auf der Oberseite eines mikroelektronischen Substrats ausgebildet ist, mittels einer Laservorrichtung mit verteilter Rückkopplung, die gebildet wird durch die Kombination aus einer Struktur des SOI-Typs mit einem Teil, der den Wellenleiter (3) bildet, einer Interface-Schicht (4), einem Stapel aus III-V-Halbleiter-Verstärkungsmaterialien (5), die den Wellenleiter (3) teilweise abdecken, und einem optischen Gitter (9), das in der Oberseite des Wellenleiters ausgebildet ist, wobei der Gitterabstand so ausgewählt ist, dass die optische Leistung des Laserstrahls in einer Schleife vom III-V-Stapel (5) zum Wellenleiter (3) zirkuliert, wobei der Gitterabstand so ausgewählt wird, dass:

$$\beta_{SOI}(\omega_2)+\beta_{III-V}(\omega_2)= 2n\pi/a,$$

und

$$\beta_{SOI}(\omega_2) \neq \beta_{III-V}(\omega_2)$$

mit:

a: Gitterabstand,
$\omega_2$: Modusfrequenz,
$\beta_{SOI}$: Ausbreitungskonstante im Wellenleiter,
$\beta_{III-V}$: Ausbreitungskonstante im Stapel,
n: eine ganze Zahl.

**2.** Verfahren nach Anspruch 1, wobei die Gitterlänge so ausgewählt wird, dass:

$$R = \tanh^2(2\kappa L)$$

mit:

> L: Gitterlänge,
> $\kappa$: Gegenrichtungs-Kopplungskonstante,
> R: Gitterreflektivität

so dass R zwischen 0,60% und 0,99% liegt.

3. Eine Laservorrichtung mit verteilter Rückkopplung, die gebildet wird durch die Kombination aus einer Struktur des SOI-Typs mit einem Teil der einen Wellenleiter (3) bildet, ausgebildet auf der Oberseite eines mikroelektronischen Substrats, einer Interface-Schicht (4), einem Stapel aus III-V-Halbleiter-Verstärkungsmaterialien (5), die den Wellenleiter (3) teilweise abdecken, und einem optischen Gitter (9), das in der Oberseite des Wellenleiters ausgebildet ist, dessen Periode so ausgewählt ist, dass sie eine Schleifenzirkulation der optischen Leistung von dem III-V-Stapel (5) zum Wellenleiter (3) erlaubt, wobei das Gitter aus periodischen Ausnehmungen gebildet ist, die in der Oberseite eines Silizium-Wellenleiters, der mit Siliziumoxid umhüllt ist, ausgebildet sind, und wobei der Gitterschritt so ausgewählt ist, dass:

$$\beta_{SOI}(\omega_2) + \beta_{III-V}(\omega_2) = 2n\pi/a,$$

*und*

$$\beta_{SOI}(\omega_2) \neq \beta_{III-V}(\omega_2)$$

mit:

> a: Gitterabstand,
> $\omega_2$: Modusfrequenz,
> $\beta_{SOI}$: Ausbreitungskonstante im Wellenleiter,
> $\beta_{III-V}$: Ausbreitungskonstante im Stapel,
> n: eine ganze Zahl.

4. Vorrichtung nach Anspruch 3, wobei die Gitterlänge so ausgewählt wird, dass:

$$R = \tanh^2(2\kappa L)$$

mit:

> L: Gitterlänge,
> $\kappa$: Gegenrichtungs-Kopplungskonstante,
> R: Gitterreflektivität

so dass R zwischen 0,60% und 0,99% liegt.

**Claims**

1. A method for introducing light into a waveguide (3) formed on the upper surface of a microelectronics substrate, by means of a distributed feedback laser device formed by the association of an SOI-type structure having a portion forming said waveguide (3), of an interface layer (4), of a stack of III-V semiconductor gain materials (5) partially covering the waveguide (3), and of an optical grating (9) formed in the upper surface of the waveguide, wherein the grating step is selected so that the optical power of the laser beam circulates in a loop from the III-V stack (5) to the waveguide (3), wherein the grating step is selected so that:

$$\beta_{SOI}(\omega_2) + \beta_{III-V}(\omega_2) = 2n\pi/a,$$

*and*

$$\beta_{SOI}(\omega_2) \neq \beta_{III\text{-}V}(\omega_2)$$

with:

a: grating step,
$\omega_2$ : mode frequency,
$\beta_{SOI}$: propagation constant in the waveguide,
$\beta_{III\text{-}V}$: propagation constant in said stack,
n: an integer.

2. The method of claim 1, wherein the grating length is selected so that:

$$R = \tanh^2(2\kappa L)$$

with:

L: grating length,
$\kappa$: contradirectional coupling constant,
R: grating reflectivity

so that R ranges between 0.60% and 0.99%.

3. A distributed feedback laser device formed by the association of an SOI-type structure having a portion forming a waveguide (3) formed, on the upper surface of a microelectronic substrate, of an interface layer (4), of a stack of III-V semiconductor gain materials (5) partially covering the waveguide (3), and of an optical grating (9) formed in the upper surface of the waveguide having its period selected to allow a loop circulation of the optical power from the III-V stack (5) to the waveguide (3), wherein the grating is formed of periodic recesses dug into the upper surface of a silicon waveguide clad with silicon oxide, and wherein the grating step is selected so that:

$$\beta_{SOI}(\omega_2) + \beta_{III\text{-}V}(\omega_2) = 2n\pi/a,$$

*and*

$$\beta_{SOI}(\omega_2) \neq \beta_{III\text{-}V}(\omega_2)$$

with:

a: grating step,
$\omega_2$: mode frequency,
$\beta_{SOI}$: propagation constant in the waveguide,
$\beta_{III\text{-}V}$: propagation constant in said stack,
n: an integer.

4. The device of claim 3, wherein the grating length is selected so that:

$$R = \tanh^2(2\kappa L)$$

with:

L: laser length,
$\kappa$: contradirectional coupling constant,

R: grating reflectivity

so that R ranges between 0.60% and 0.99%.

Fig 1

Fig 2

Fig 3

Fig 4

Fig 5

Fig 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040004217 A